# EUROPEAN PATENT SPECIFICATION

(11) **EP 3 199 987 B1**
(45) Date of publication and mention of the grant of the patent: **04.12.2019**
(21) Application number: 16205289.8
(22) Date of filing: 20.12.2016
(51) Int. Cl.: G02B 5/18, G02B 5/30, G02F 1/1335, B23K 26/00, B23K 26/38, B23K 26/402, G03F 7/00, F21V 8/00, B23K 26/53, B23K 103/00, B23K 101/40, B23K 26/364

(54) **PATTERN STRUCTURE AND METHOD OF MANUFACTURING THE SAME**
MUSTERSTRUKTUR UND VERFAHREN ZUR HERSTELLUNG DAVON
STRUCTURE DE MOTIF ET SON PROCÉDÉ DE FABRICATION

(30) Priority: 01.02.2016 KR 20160012457
(43) Date of publication of application: 02.08.2017
(73) Proprietor: Samsung Electronics Co., Ltd., Gyeonggi-do 16677 (KR)
(72) Inventor: LEE, Sunghoon, 16678, Gyeonggi-do (KR); CHUNG, Jaeseung, 16678, Gyeonggi-do (KR); KIM, Dongouk, 16678, Gyeonggi-do (KR); KIM, Hyunjoon, 16678, Gyeonggi-do (KR); PARK, Joonyong, 16678, Gyeonggi-do (KR); BAE, Jihyun, 16678, Gyeonggi-do (KR); SHIN, Bongsu, 16678, Gyeonggi-do (KR); SHIM, Dongsik, 16678, Gyeonggi-do (KR); HONG, Seogwoo, 16678, Gyeonggi-do (KR)
(74) Representative: Elkington and Fife LLP

(56) References cited:
- EP-A1- 2 258 512
- EP-A1- 2 983 021
- EP-A2- 2 942 667
- US-A- 6 057 898
- US-A1- 2013 153 534
- US-A1- 2015 209 898

## Description

### FIELD OF THE INVENTION

Apparatuses and methods consistent with exemplary embodiments relate to a pattern structure and a method of manufacturing the pattern structure, and more particularly, to a large-sized pattern structure having a reduced seam, and a method of manufacturing the pattern structure.

### BACKGROUND OF THE INVENTION

The development of liquid crystal displays (LCDs), which are typical display devices, has moved towards the development of larger sized displays with higher resolution and towards the use of such displays in 3D televisions (TVs). To aid in this development, technologies to apply nanoscale functional structures to LCD structures have been introduced. For example, when a nanoscale grating is formed on a surface of a backlight unit located under an LCD panel, light output from the surface of a backlight unit has directivity due to a diffraction phenomenon, which may be used to implement a non-glasses 3D TV. Also, when an absorptive polarization film of an LCD panel is replaced with a wire grid polarizer, the improvement in brightness required to implement a high resolution display may be facilitated.

To apply a nanoscale functional structure to an LCD structure, a technology is needed to form a fine linewidth in the semiconductor-level on a large area of a display level. For example, a tiling technology enables the formation of a large-sized pattern structure by forming a fine structure on a unit pattern structure, on which a semiconductor process can be performed, and physically connecting a plurality of unit pattern structures. However, the tiling technology utilizes a physical bonding method, and therefore, a seam is generated between the unit pattern structures. Accordingly, when a large size nanoscale grating or wire grid polarizer is manufactured using the tiling technology, if the size of a seam is larger than a certain level, a defect may be seen on a screen of the resultant display panel.

EP 2 983 021 discloses a pattern structure includes a plurality of pattern structure units arranged on a same plane, where each of the plurality of pattern structure units includes a plurality of microstructures defined on a surface thereof and having a width of less than about 1 micrometer (µm); and a connection layer disposed between the plurality of pattern structure units and having a width of less than about 10 µm, where the connection layer connects the plurality of pattern structure units to each other.

EP 2 258 512 discloses a method of manufacturing a pattern structure, the method comprising: forming a fine pattern on a wafer;cutting the wafer by irradiating the wafer with a laser, thereby forming a unit pattern structure having the fine pattern.

### SUMMARY OF THE INVENTION

According to an aspect of an exemplary embodiment, a method of manufacturing a pattern structure includes forming a fine pattern on a wafer, cutting the wafer by irradiating the wafer with a laser while changing a focal depth of the laser, thereby forming a unit pattern structure having the fine pattern, and bonding cutting surfaces of at least two unit pattern structures, in which the cutting of the wafer comprises moving a focal position of the laser in a horizontal direction, substantially parallel to the first surface, and changing the focal depth of the laser, such that the unit pattern structure has a cutting surface profile in which a first surface of the unit pattern structure on which the fine pattern is formed protrudes, in the horizontal direction, from a second surface of the unit pattern structure that is opposite to the first surface.

A first region from the first surface to a first depth in a depth direction may have a vertical cutting surface, substantially perpendicular to the first surface, and a second region from the first depth to the second surface may have a cutting surface that is at least partially inclined with respect to the first surface.

The cutting surface of the first region may protrude farther in the horizontal direction toward an edge of the unit pattern structure than the cutting surface of the second region.

A thickness of the first region may be less than about 150 µm.

The moving of the focal position of the laser in the horizontal direction and the changing the focal depth of the laser may include sequentially changing the focal depth of the laser in a direction from the second surface toward the first surface, and moving the focal position of the laser in the horizontal direction toward the edge of the wafer when the focal depth of the laser is changed.

The sequentially changing of the focal depth of the laser may be performed until the focal depth of the laser reaches the first depth.

The moving of the focal position of the laser may include gradually moving the focal position of the laser in the horizontal direction toward the edge of the wafer whenever the focal depth of the laser is changed.

The moving of the focal position of the laser may include maintaining the focal position of the laser in the horizontal direction until the focal depth of the laser reaches a second depth between the first depth and the second surface, and moving the focal position of the laser in the horizontal direction toward the edge of the wafer while the focal depth of the laser is changed between the second depth and the first depth.

A distance by which the focal position of the laser is moved in the horizontal direction may gradually increase as the focal depth of the laser is moved closer to the first depth and farther from the second depth.

A distance between the first depth and the second depth may be in a range of about 50 µm to about 200 µm.

The bonding of the cutting surfaces of the at least two unit pattern structures may include arranging the at least two unit pattern structures on a substrate, providing photocurable or thermosetting resin in a liquid state between the at least two unit pattern structures, moving the at least two unit pattern structures such that the at least two unit pattern structures closely contact each other, and curing the photocurable or thermosetting resin by irradiation with ultraviolet (UV) light or heat.

The arranging of the at least two unit pattern structures on the substrate may include arranging the at least two unit pattern structures such that the cutting surfaces of the at least two unit pattern structures face each other.

The moving of the at least two unit pattern structures such that the at least two unit pattern structures closely contact each other may include moving the at least two unit pattern structures toward each other such that the cutting surfaces of the at least two unit pattern structures closely contact each other, and distributing the photocurable or thermosetting resin in a liquid state in a gap between the at least two unit pattern structures, above fine patterns of the at least two unit pattern structures, and under second surfaces of the at least two unit pattern structures.

The distributing of the photocurable or thermosetting resin in a liquid state may include providing a base layer to entirely cover the fine patterns of the at least two unit pattern structures, and matching vertical positions of the fine patterns of the at least two unit pattern structures with each other by pressing the base layer towards the at least two unit pattern structures.

The method may further include detaching the base layer from the fine patterns of the at least two unit pattern structures, after the curing of the photocurable or thermosetting resin.

When the base layer is detached, cured resin arranged on the fine patterns of the at least two unit pattern structures may be removed with the base layer, and cured resin arranged in the gap between the at least two unit pattern structures and under the second surfaces of the at least two unit pattern structures may be left.

A gap between the cutting surfaces of the at least two unit pattern structures bonded to each other may be greater than about 0 µm and less than or equal to about 10 µm.

According to an aspect of another exemplary embodiment, a pattern structure comprises a first unit pattern structure comprising a first surface, on which a fine pattern is formed, a second surface opposite to the first surface, and a third surface extending from the first surface to the second surface; and a second unit pattern structure comprising a first surface on which a fine pattern is formed, a second surface opposite to the first surface, and a third surface extending from the first surface to the second surface, and wherein the third surface of first unit pattern structure is bonded to the third surface of the second unit pattern structure.

In each of the first unit pattern structure and the second unit pattern structure, the third surface has a sectional profile in which the first surface protrudes farther, in a horizontal direction substantially parallel to the first surface, from the second surface.

A first region of the sectional profile extends from the first surface to a first depth in a depth direction and is substantially perpendicular to the first surface. A second region of the sectional profile extends from the first depth to the second surface and is at least partially inclined with respect to the first surface.

The section of the first region may protrude farther in the horizontal direction, toward an edges of the first and second unit pattern structures than the section of the second region.

A thickness of the first region may be within about 150 µm.

The second region from the second surface to the first depth may be inclined as a whole.

A region from the second surface to a second depth between the first depth and the second surface may be substantially perpendicular to the first surface, and a region from the second depth to the first depth may be inclined with respect to the first surface.

The region from the second depth to the first surface may have an inclination that gradually increases from the second depth toward the first depth.

A thickness between the first depth and the second depth may be in a range between about 50 µm to about 200 µm.

The pattern structure may further include a resin layer arranged in a gap between the third surface of the first unit pattern structure and the third surface of the second unit pattern structure and under the second surfaces of the first unit pattern structure and the second unit pattern structure.

A thickness of the resin layer under the second surface of the first unit pattern structure and a thickness of the resin layer under the second surface of the second unit pattern structure may be different from each other such that vertical positions of the first surface of the first unit pattern structure and the first surface of the second unit pattern structure are the same.

The gap between the third surface of the first unit pattern structure and the third surface of the second unit pattern structure may be greater than about 0 µm and less than or equal to about 10 µm.

According to an aspect of another exemplary embodiment, a method of forming a grating using a stamp, the stamp comprising two or more unit pattern regions adjacent to each other and a seam greater than 0 µm and less than or equal to about 10 µm between the adjacent unit pattern regions, each of the unit pattern regions having a pattern, the method includes pressing a resin layer with the stamp such that the resin layer fills complementary patterns of the patterns of the unit pattern regions, curing the complementary patterns of the resin layer, and detaching the stamp from the cured complementary patterns of the resin layer and thereby obtaining the grating having a seam between the complementary patterns greater than 0 µm and less than or equal to about 10 µm.

The stamp further may include a base layer having a flat surface, and a resin portion disposed on the flat surface of the base layer. The unit pattern regions may be disposed on the resin portion.

The stamp is manufactured using a pattern structure as a master mold. The pattern structure includes a first unit pattern structure having a first surface on which a fine pattern is formed and a second surface opposite to the first surface, and a second unit pattern structure having a first surface on which a fine pattern is formed and a second surface opposite to the first surface, and the second unit pattern structure being bonded to the first unit pattern structure, in which the first unit pattern structure and the second unit pattern structure are bonded to each other by a third surface between the first surface and the second surface, and the third surface has a sectional profile in which the first surface where the fine patterns are formed protrudes farther, in a horizontal direction substantially parallel to the first surface, from the second surface.

The grating may have the same pattern as the fine pattern of the pattern structure.

The stamp may be manufactured by distributing resin for replicating the stamp on the pattern structure, pressing the resin for replicating the stamp by disposing a base layer on the resin for replicating the stamp curing the resin for replicating the stamp, and detaching the base layer from the pattern structure.

The grating may be a grating layer disposed on a surface of a backlight unit for a liquid crystal display or a metal wire pattern of a wire grid polarizer for a liquid crystal display.

The seam of the grating may be disposed directly under a black matrix of the liquid crystal display and may have a width smaller than a width of the black matrix.

### BRIEF DESCRIPTION OF THE DRAWINGS

These and/or other exemplary aspects and advantages will become apparent and more readily appreciated from the following description of the exemplary embodiments, taken in conjunction with the accompanying drawings in which:
FIGS. 1 to 3 are perspective views of a method of manufacturing a large-sized pattern structure by using a tiling technology, according to an exemplary embodiment;
FIG. 4 is a cross-sectional view of a method of forming a unit pattern structure by cutting a wafer, according to an exemplary embodiment;
FIG. 5 is a cross-sectional view of an example of a profile of a cutting surface of the unit pattern structure manufactured by the method of FIG. 4.
FIG. 6 is a schematic cross-sectional view of a state in which two unit pattern structures manufactured by the method of FIG. 4 are bonded to each other;
FIGS. 7 and 8 are schematic cross-sectional views of a method of forming a unit pattern structure by cutting a wafer, according to another exemplary embodiment;
FIGS. 9 to 12 are cross-sectional views of a method of manufacturing a large-sized pattern structure by bonding a plurality of unit pattern structures, according to an exemplary embodiment;
FIGS. 13 and 14 are cross-sectional views of a method of forming a grating layer in a large area on a surface of a backlight unit;
FIG. 15 is a cross-sectional view of a liquid crystal display (LCD) including the backlight unit manufactured by the method illustrated in FIGS. 13 and 14;
FIGS. 16 to 21 are cross-sectional views of a method of forming a large-sized metal wire grid polarizer;
FIG. 22 is a cross-sectional view of an LCD including the metal wire grid polarizer manufactured by the method illustrated in FIGS. 16 to 21; and
FIGS. 23 and 24 are perspective views of large-sized pattern structures manufactured by using a tiling technology, according to other exemplary embodiments.

### DETAILED DESCRIPTION OF THE EMBODIMENTS

Reference will now be made in detail to exemplary embodiments which are illustrated in the accompanying drawings, wherein like reference numerals refer to like elements throughout. Also, the size of each layer illustrated in the drawings may be exaggerated for convenience of explanation and clarity. In this regard, the exemplary embodiments may have different forms and should not be construed as being limited to the descriptions set forth herein. Accordingly, the exemplary embodiments are merely described below, by referring to the figures, to explain aspects of the present description. In a layer structure, when a constituent element is disposed "above" or "on" to another constituent element, the constituent element may be only directly on the other constituent element or above the other constituent elements in a non-contact manner.

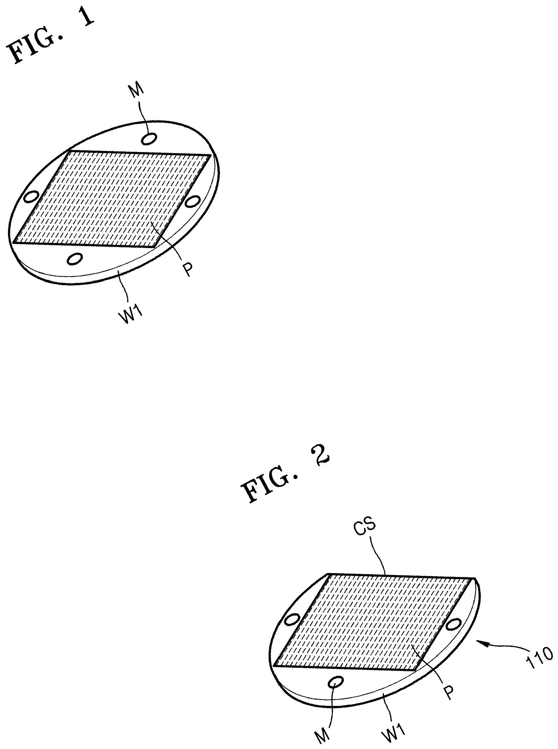

FIGS. 1 to 3 are perspective views of a method of manufacturing a large-sized pattern structure by using a tiling technology, according to an exemplary embodiment.

Referring to FIG. 1, a first wafer W1, on which a fine pattern P is formed, may be provided. The first wafer W1 may be, for example, a silicon wafer. However, the first wafer W1 is not limited to a silicon wafer, and various other wafers such as a compound semiconductor wafer or a sapphire wafer may be selected as desired. The fine pattern P may be formed on the first wafer W1 by using a semiconductor patterning process such as lithography or etching. Also, the fine pattern P may have a nanoscale of, for example, several nanometers to several hundred nanometers, but the present disclosure is not limited thereto. For example, the fine pattern P may have a microscale of several micrometers to several hundred micrometers, as desired.

At least one alignment mark M may also be formed on the first wafer W1. The alignment mark M may be formed in an area of the wafer W1 on which the fine pattern P is not formed. For example, as shown in FIG. 1, the first wafer W1 has a circular shape, and the fine pattern P is formed in a rectangular area on the first wafer W1. A plurality of the alignment marks M may be formed on one or more portions of the wafer W1 which are peripheral to the region on which the fine pattern P is formed. The alignment mark M may be formed by the same process as the fine pattern P when the fine pattern P is formed using a semiconductor process.

Referring to FIG. 2, a unit pattern structure 110, including the fine pattern P may be formed by cutting the first wafer W1. The unit pattern structure 110 may have a cutting surface CS that is formed by cutting the first wafer W1. The cutting surface CS may be a junction surface at which the unit pattern structure 110 is to be coupled to another unit pattern structure 110. Although FIG. 2 illustrates that only one side surface of the first wafer W1 is cut, two or more surfaces may be cut as desired.

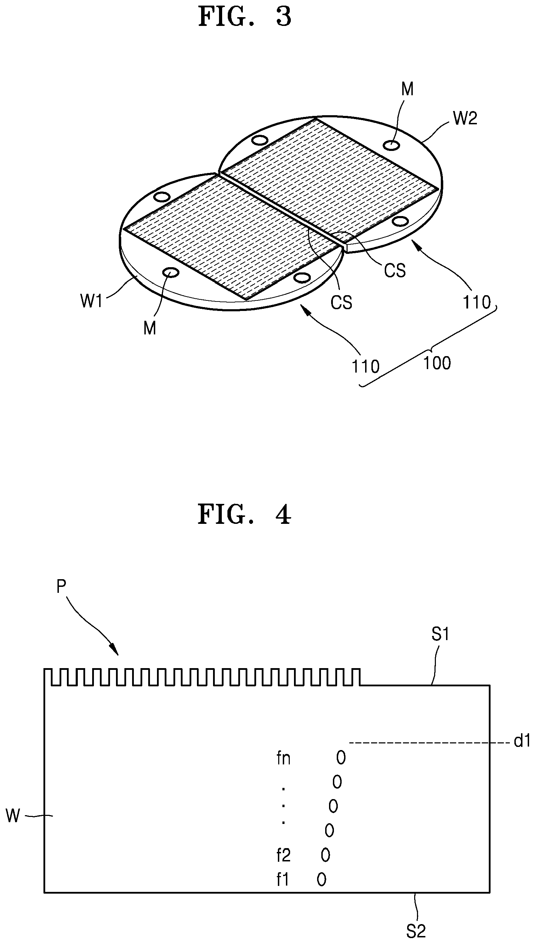

Referring to FIG. 3, a second wafer W2, on which another fine pattern P is formed, may be provided. Then, another unit pattern structure 110 may be further formed by cutting the second wafer W2. The two unit pattern structures 110 are bonded to each other such that the cutting surfaces CS face each other, thereby forming a pattern structure 100. When the two unit pattern structures 110 are bonded to each other, the two unit pattern structures 110 may be precisely aligned by using one or more of the alignment marks M. As a result, the pattern structure 100 of a large size may be manufactured using a tiling method in which two or more unit pattern structures 110 are bonded according to the above-described method.

FIG. 4 is a cross-sectional view of a method of forming the unit pattern structure 110 by cutting the wafer W, according to an exemplary embodiment. Referring to FIG. 4, for example, an edge of the wafer W may be cut by using stealth dicing technology. Stealth dicing technology is a technology in which a silicon wafer is cut using a laser and without surface damage. According to stealth dicing technology, the wafer W may be cut by irradiating the wafer W with a laser by sequentially changing focal depths f1, f2, ..., and fn of the laser. The stealth dicing technology is suitable for cutting the wafer W without damaging the fine pattern P of the unit pattern structure 110. However, as a result of stealth dicing technology, a roughness of the cutting surface CS is high, and therefore a seam between the unit pattern structures 110 may be increased when the pattern structure 100 is manufactured.

According to an exemplary embodiment, as illustrated in FIG. 4, while performing the stealth dicing, whenever the focal depth (e.g. f1, f2, ..., and fn) of the laser is changed, the focal position of the laser may be moved in a horizontal direction. In detail, scanning of the laser may proceed from a second surface S2 of the unit pattern structure 110, that is opposite a first surface S1 of the unit pattern structure 110 on which the fine pattern P is formed, in a direction toward the first surface S1. In other words, as the focal depth of the laser is sequentially changed by a certain interval from the first focal depth f1 to the n-th focal depth fn in a direction from the second surface S2 to the first surface S1, a portion of the wafer W may be locally melted. In this state, when the focal depth of the laser is moved toward the first surface S1, the focal position of the laser may be sequentially moved in the horizontal direction toward an edge of the wafer W. For example, the focal position of the laser in the horizontal direction at the second focal depth f2 of the laser is moved farther toward the right, as shown in FIG. 4, than the focal position of the laser in the horizontal direction at the first focal depth f1 of the laser, so as to be closer to the edge of the wafer W. A degree of the movement of the focal position of the laser in the horizontal direction may be several micrometers to several tens of micrometers. As such, because the focal position of the laser in the horizontal direction is moved, the stealth dicing technology as illustrated in FIG. 4 may be referred to as a shift stealth dicing technology.

When the focal depth reaches a certain depth, for example, a first depth d1, while changing the focal depth of the laser according to the above-described method, the scanning of the laser may be stopped. When the focal depth of the laser is close to the first surface S1, a crack may be generated from the focal depth of the laser to the first surface S1 so that the wafer W may be naturally cut without further irradiation of the laser.

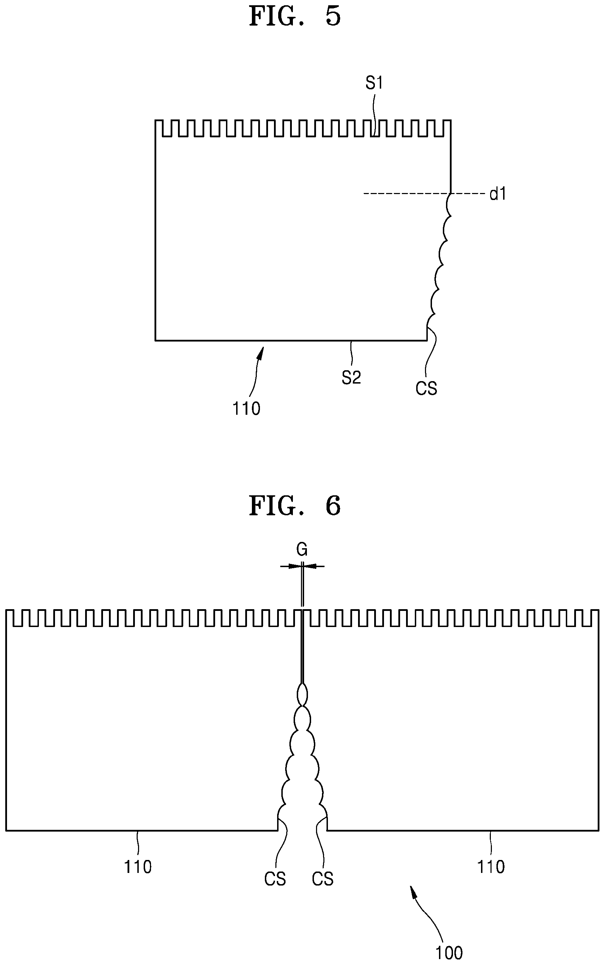

FIG. 5 is a cross-sectional view of an example of a profile of the cutting surface CS of the unit pattern structure 110 manufactured by the method of FIG. 4. Referring to FIG. 5, since the focal position of the laser is moved in the horizontal direction whenever the focal depth of the laser is changed, the profile of the cutting surface CS of the unit pattern structure 110 may have a shape such that the first surface S1, on which the fine pattern P is formed, protrudes farther in the horizontal direction than the second surface S2 that is the opposite side of the first surface S1. In detail, a first region, from the first surface S1 to the first depth d1 in a depth direction, is cut due to the crack that is naturally generated so that a relatively smooth and vertical cutting surface is formed in this first region. A second region, from the first depth d1 to the second surface S2 in the depth direction, may have a cutting surface that is inclined overall. The cutting surface of the second region may not be smooth unlike the first region and but may be rough due to a plurality of melted portions arranged in the depth direction. As illustrated in FIG. 5, the relatively smooth cutting surface of the first region protrudes farther toward the edge of the unit pattern structure 110 than the cutting surface in the second region. The second region may be inwardly concave as compared to the first region, or may include a plurality of concave portions. For example, the first depth d1, and thus a thickness of the first region from the first surface S1 to the first depth d1 in the depth direction, may be within about 150 µm. More specifically, the first depth d1, and thus the thickness of the first region, may be in a range of about 50 µm to about 150 µm.

FIG. 6 is a schematic cross-sectional view of a state in which the two unit pattern structures 110, manufactured by the method of FIG. 4 are bonded to each other. Referring to FIG. 6, the pattern structure 100 of a large size may be formed by bonding to each other the cutting surfaces CS of the two unit pattern structures 110 manufactured by the method of FIG. 4. In this state, the portions of the cutting surfaces CS which are actually bonded are the first regions of the cutting surfaces CS, which protrude farther directions toward the edges of the respective unit pattern structure 110, whereas the second regions of the cutting surfaces CS do not substantially contact each other. Instead, an empty space may be formed between the second regions of the cutting surfaces CS of the two unit pattern structures 110. As such, since the first regions of the cutting surfaces CS, that are relatively smooth, contact each other and the second regions of the cutting surfaces CS, having relatively rough surfaces, do not contact each other, a width of a seam between the two unit pattern structures 110 may be reduced when the pattern structure 100 is manufactured. For example, a gap G, between the cutting surfaces CS of the two unit pattern structures 110 which are bonded to each other, may be greater than 0 µm and equal to or less than 10 µm.

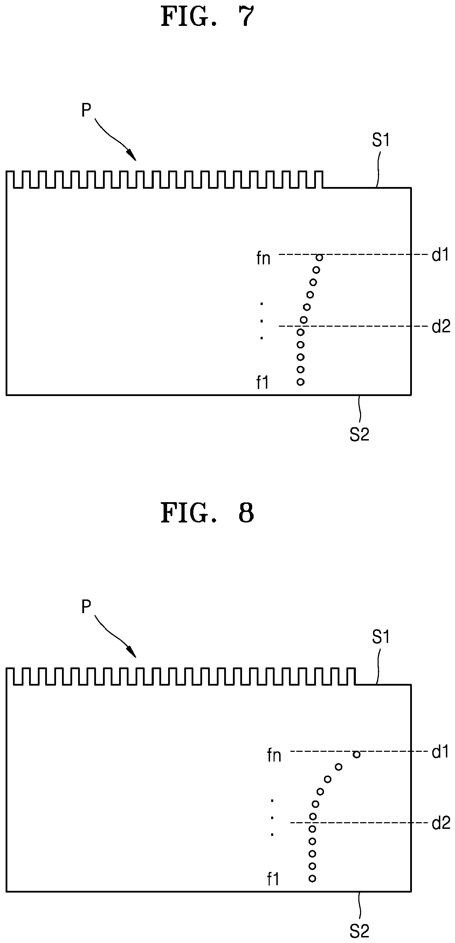

Although, in FIG. 4, whenever the focal depth of the laser is changed toward the first surface S1, the focal position of the laser is described to be gradually moved in the horizontal direction, the present disclosure is not limited thereto. The focal position of the laser may be moved in any method that allows the smooth first regions to protrude and the second regions to be engraved -- i.e. recessed with respect to the first regions. For example, FIGS. 7 and 8 are schematic cross-sectional views of a method of forming the unit pattern structure 110 by cutting the wafer W, according to another exemplary embodiment.

Referring to FIG. 7, the scanning of the laser may proceed from the second surface S2 of the unit pattern structure 110 in a direction toward the first surface S1. In this case, the focal position of the laser is not moved in the horizontal direction until the focal depth of the laser reaches a second depth d2 between the first depth d1 and the second surface S2. Then, while the focal depth of the laser is changed between the second depth d2 and the first depth d1, the focal position of the laser may be moved in the horizontal direction toward the edge of the wafer W. Then, the cutting surface CS of the unit pattern structure 110 may have a profile including a relatively smooth vertical surface from the first surface S1 to the first depth d1, a relatively rough inclined surface from the first depth d1 to the second depth d2, and a relatively rough vertical surface from the second depth d2 to the second surface S2. Accordingly, the second region, from the first depth d1 to the second surface S2, may have an at least partially inclined cutting surface. In this case, since the first region of the cutting surface CS of the unit pattern structure 110 protrudes farther than the other regions in a direction toward the edge of the unit pattern structure 110, when the pattern structure 100 is manufactured, the width of a seam between the two unit pattern structures 110 may be reduced. In order to allow the second region of the cutting surface CS of the unit pattern structure 110 to be sufficiently recessed, a distance between the first depth d1 and the second depth d2 may have a range of, for example, about 50 µm to about 200 µm.

Referring to FIG. 8, in order to allow the second region of the cutting surface CS of the unit pattern structure 110 to be further sufficiently recessed, as the focal depth of the laser is closer to the first depth d1 from the second depth d2, a distance by which the focal position of the laser is moved in the horizontal direction may be gradually increased. Then, the cutting surface CS of the unit pattern structure 110 may have an inclined surface having an inclination with respect to the vertical direction that gradually increases from the second depth d2 toward the first depth d1.

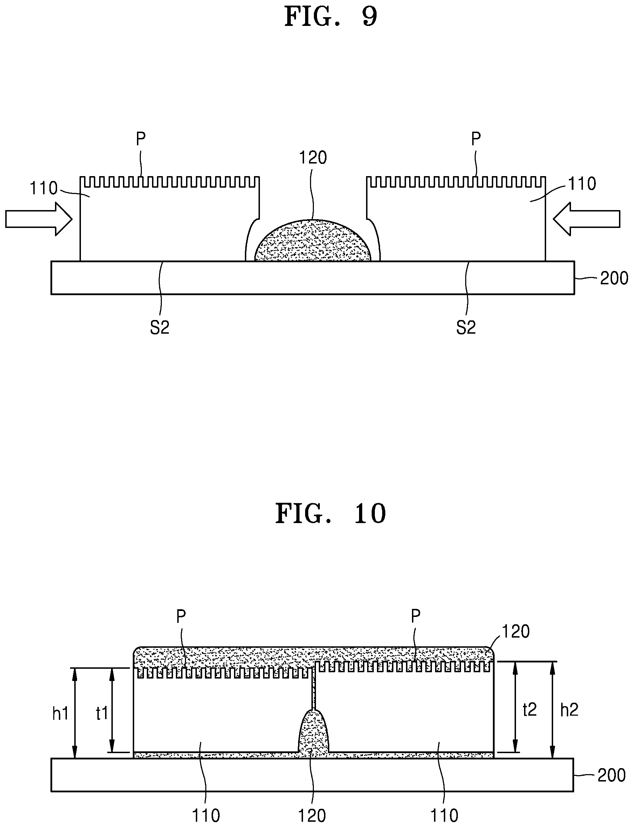

FIGS. 9 to 12 are cross-sectional views of a method of manufacturing the pattern structure 100 of a large size by bonding the unit pattern structures 110, according to an exemplary embodiment.

First, referring to FIG. 9, the unit pattern structures 110 are arranged on a substantially flat substrate 200. The unit pattern structures 110 may be arranged such that the fine pattern P of each of the unit pattern structures 110 faces upward and the second surface S2 of each of the unit pattern structures 110 faces the substrate 200. Although the substrate 200 may be a glass substrate, the present disclosure is not limited thereto and a substrate formed of a plastic material may be employed if the substrate has a flat and smooth surface. Also, resin 120 that is photocurable or thermosetting in a liquid state may be arranged in an empty space between the unit pattern structures 110. For example, the resin 120 may include an acrylate based material. Also, photocompressive or thermocompressive resin instead of photocurable or thermosetting resin may be used as the resin 120. In this case, for example, the resin 120 may include a polyurethane based material.

Next, referring to FIG. 10, the unit pattern structures 110 are arranged such that the cutting surfaces CS of the unit pattern structures 110 may closely contact each other. In doing so, the fine patterns P of the unit pattern structures 110 may be precisely matched with each other by using one or more the alignment marks M (see FIGS. 1-3). When the unit pattern structures 110 closely contact each other, the resin 120 between the unit pattern structures 110 may be distributed in the gap G between the cutting surfaces CS of the unit pattern structures 110, in a gap between the substrate 200 and the second surfaces S2 of the unit pattern structures 110, and over the fine patterns P of the unit pattern structures 110. The resin 120 may have a viscosity lower than, for example, about 1000 cps so that the resin 120 may be easily distributed.

As illustrated in FIG. 10, the thicknesses of the two unit pattern structures 110 may not be completely identical to each other due to a deviation in the manufacturing process. For example, the unit pattern structure 110 at the left side of FIG. 10 may have a thickness of t1, whereas the unit pattern structure 110 at the right side of FIG. 10 may have a thickness of t2. In this case, the fine pattern P of the unit pattern structure 110 at the left side may be located at a height of h1 and the fine pattern P of the unit pattern structure 110 at the right may be located at a height of h2, different from h1, as shown.

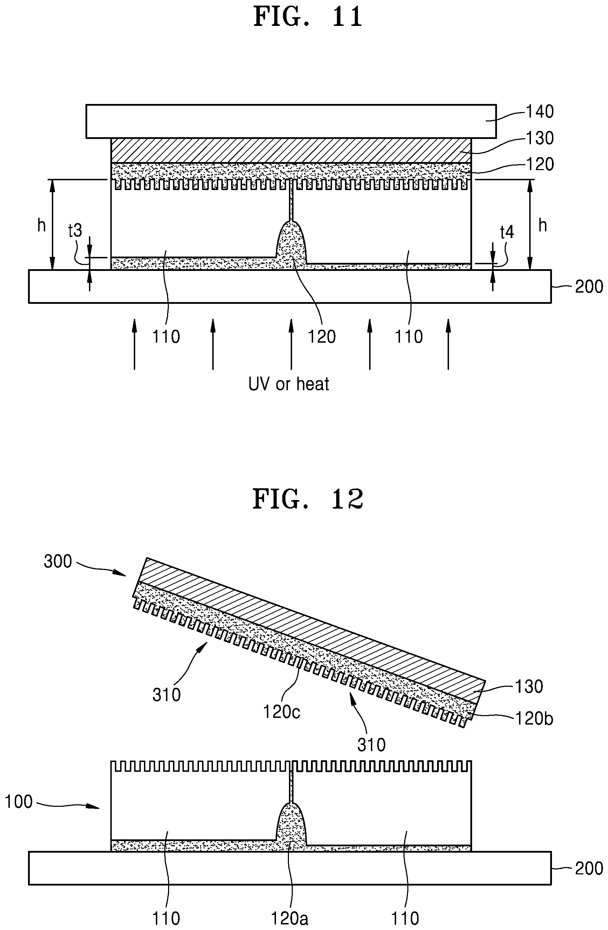

Referring to FIG. 11, a base layer 130 is arranged above the resin 120 distributed on the fine patterns P of the unit pattern structures 110. The base layer 130 ultimately functions as a support portion for a stamp and may be formed of, for example, a plastic material such as polyethylene terephthalate (PET). The base layer 130 may be arranged such that a flat surface of the base layer 130 contacts the resin 120. The base layer 130 is pressed by a pressing layer 140 from above. Although FIG. 11 illustrates a pressing layer 140 that is wide and flat, the present disclosure is not limited thereto and, for example, the base layer 130 may be pressed toward the substrate 200 by rolling a cylindrical press roller over the base layer 130.

When the base layer 130 is pressed toward the unit pattern structures 110, the resin 120 distributed between the base layer 130 and the unit pattern structures 110 may function as a buffer member for preventing damage to the fine pattern P. Also, the resin 120 distributed between the substrate 200 and the unit pattern structures 110 may function as a compensation layer for adjusting the heights of the fine patterns P of the two unit pattern structures 110. For example, when the base layer 130 is pressed by the pressing layer 140, the thickness of the resin 120 distributed between the substrate 200 and the unit pattern structures 110 may vary such that pressure respectively acting on the base layer 130 and the two unit pattern structures 110 is equalized. In this way, the fine patterns P of the two unit pattern structures 110 may be aligned at the same height h. In other words, positions in a vertical direction of the fine patterns P of the two unit pattern structures 110 may be equalized in this way such that they match each other. Accordingly, the thickness of the resin 120 under the second surfaces S2 of the unit pattern structures 110 may partially vary. For example, a portion of the resin 120 under the unit pattern structure 110 at the left side in FIG. 11 may have a thickness t3, whereas a portion of the resin 120 under the unit pattern structure 110 at the right in FIG. 11 may have a thickness t4.

After the positions of the fine patterns P of the unit pattern structures 110 are matched with each other in the vertical direction, heat or light, for example, ultraviolet (UV) light, is applied to the resin 120. Although FIG. 11 illustrates that heat or light is applied in a direction from the substrate 200 toward the resin 120, the direction in which heat or light is applied is not particularly limited. For example, in the case in which the base layer 130 is formed of a transparent material with respect to a visible light or a UV light, the pressing layer 140 is removed and then heat or light may be applied in a direction from the base layer 130 to the resin 120. Alternatively, heat or light may be applied in a direction toward a side of the unit pattern structure 110. Then, the resin 120 is cured by a cross link reaction so that the two unit pattern structures 110 that are adjacent to each other may be bonded to each other. Also, when the resin 120 is photocompressive or thermocompressive resin, a solvent in the resin 120 is vaporized and thus the resin 120 that is photocompressive or thermocompressive is compressed so that the adjacent two unit pattern structures 110 may be bonded to each other.

Referring to FIG. 12, the base layer 130 is removed after the resin 120 is cured. In this state, a resin portion 120b distributed over the fine pattern P of the unit pattern structures 110 is detached, along with the base layer 130, from the fine pattern P of the unit pattern structures 110. A resin portion 120a distributed in the gap G between the cutting surfaces CS of the unit pattern structures 110 and the gap between the substrate 200 and the second surfaces S2 of the unit pattern structures 110 remains in the pattern structure 100 formed by bonding the unit pattern structures 110. In particular, an intermediate portion 120c having a thin thickness of the resin 120 inserted between the fine patterns P above the gap G between the cutting surfaces CS of the unit pattern structures 110 may be detached with the base layer 130 from the pattern structure 100. As such, the resin portion 120b attached on the base layer 130 has a pattern which is complementary to the fine patterns P. Accordingly, the base layer 130 and the resin portion 120b that are detached in FIG. 12 may function as a stamp 300 for imprinting a fine pattern using an imprint technology. The stamp 300 may include at least two unit pattern regions 310 adjacent to each other on the resin portion 120b, which respectively correspond to the unit pattern structures 110. Each of the unit pattern regions 310 has a pattern which is complementary to the fine patterns P of its corresponding unit pattern structure 110. The intermediate portion 120c may be a seam between the two adjacent unit pattern regions 310.

The pattern structure 100 manufactured in the above-described method may function as a master mold for replicating the stamp 300. For example, similar to the above-described method, after resin for replicating a stamp is additionally distributed on the fine pattern P of the pattern structure 100, the base layer 130 may be arranged on the resin for replicating a stamp and pressed, and the resin for replicating a stamp may be cured and then the base layer 130 may be detached from the patter structure 100, thereby replicating the stamp 300. In other words, in a process of manufacturing the pattern structure 100 that is a master mold, a single stamp 300 may be manufactured and the stamp 300 may be additionally replicated in a subsequent additional process. In particular, according to the method illustrated in FIGS. 9 to 12, since the gap G between the cutting surfaces CS of the unit pattern structures 110 is already completely filled with the resin 120, an intrusion of the resin used for the replication of a stamp into the gap G between the cutting surfaces CS of the unit pattern structures 110 in the subsequent stamp replication process may be prevented.

The intermediate portion 120c, having a thin thickness, inserted between the fine patterns P above the gap G between the cutting surfaces CS of the unit pattern structures 110 may be a defect in the stamp 300 by which a seam may be seen. However, as described above, since the gap G between the cutting surface CS of the unit pattern structures 110 is very small and equal to or less than about 10 µm, the intermediate portion 120c existing in a seam portion may be sufficiently covered by a black matrix of a display panel. Accordingly, when a fine pattern is imprinted by using the pattern structure 100 and the stamp 300 manufactured according to the present exemplary embodiment, the seam portion is not seen because it is covered with the black matrix of a display panel and thus a defect in the display panel may be avoided.

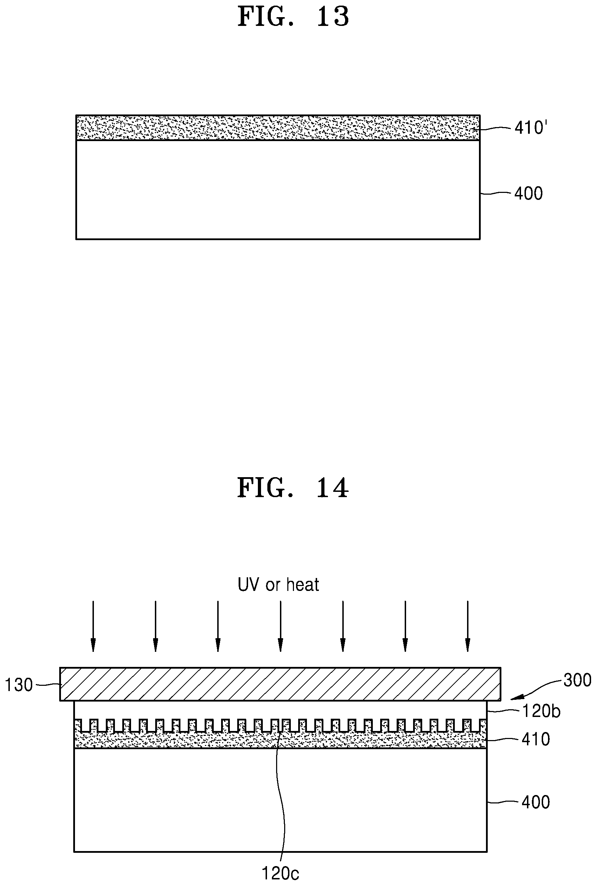

For example, FIGS. 13 and 14 are cross-sectional views of a method of forming a grating layer in a large area on a surface of a backlight unit 400 by using the above-described stamp 300.

First, referring to FIG. 13, a resin layer 410' is formed on the backlight unit 400. A surface of the backlight unit 400 may be a light-exit surface through which light exits. For example, in a case in which the backlight unit 400 is a direct type of backlight unit, the resin layer 410' may be formed on a light diffusion plate of the backlight unit 400. Also, in a case in which the backlight unit 400 is an edge type of backlight unit, the resin layer 410' may be formed on a light-exit surface of a light guide plate. The resin layer 410' may include, for example, photocurable, thermosetting, photocompressive, or thermocompressive resin.

Referring to FIG. 14, the resin layer 410' is pressed, from above, to be compressed by the stamp 300. The stamp 300 may be manufactured as illustrated in FIG. 12 or may alternately be additionally by using the pattern structure 100 as a master mold. The stamp 300 may be arranged such that the resin portion 120b, having a complementary pattern, faces the resin layer 410'. Then, the resin layer 410', having flexibility, fills in the complementary patterns of the resin portion 120b. In this state, when light, for example, UV light, or heat is applied to the resin layer 410', the resin layer 410' is cured. After the resin layer 401' is completely cured, the stamp 300 may be detached from the resin layer 410'. Then, a grating layer 410 may be formed on the surface of the backlight unit 400. The grating layer 410 formed as described above may have the same pattern as the fine pattern P of the pattern structure 100.

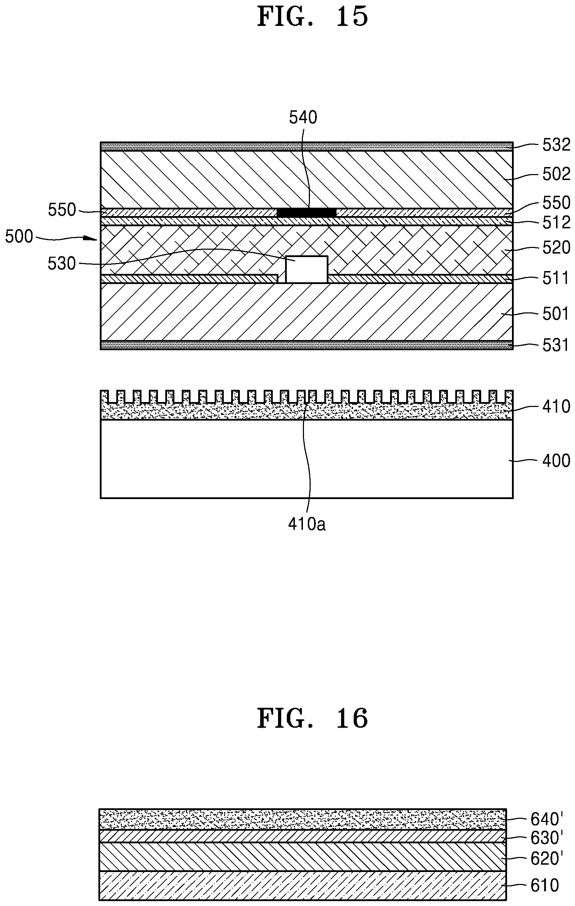

FIG. 15 is a cross-sectional view of a liquid crystal display (LCD) 500 including the backlight unit 400 manufactured by the method illustrated in FIGS. 13 and 14. Referring to FIG. 15, the LCD 500 may include a first substrate 501 and a second substrate 502, which are spaced apart from each other, a liquid crystal layer 520 disposed in a space between the first substrate 501 and the second substrate 502, and the backlight unit 400 for emitting light toward the liquid crystal layer 520. Also, a plurality of first electrodes 511 and a plurality of thin film transistors 530, connected to the first electrodes 511 and controlling an operation of the liquid crystal layer 520, are disposed on the first substrate 501. The first electrodes 511 may include a pixel electrode provided for each pixel of the LCD 500. Also, a second electrode 512, functioning as a common electrode, is disposed on the second substrate 502. A plurality of color filters 550 are disposed between the second substrate 502 and the second electrode 512 to correspond to the first electrodes 511. The color filters 550 may each transmit light having a particular color, for example, red, green, or blue. A black matrix 540 is formed between the color filters 550. The black matrix 540 may prevent cross talk between the pixels and improve contrast by blocking light. Also, a first polarizing panel 531 and a second polarizing panel 532 may be disposed on outer surfaces of the first and second substrates 501 and 502, respectively. The first polarizing panel 531 and the second polarizing panel 532 may be polyvinyl alcohol (PVA) polarizing panels that are absorptive polarizing panels, but the present disclosure is not limited thereto. For an LCD 500 having the above-described structure, since the grating layer 410 provided on the backlight unit 400 allows light to proceed in a specific direction for each pixel, a three-dimensional image in a non-glasses method may be implemented.

As exemplarily illustrated in FIG. 15, the grating layer 410 transferred onto the surface of the backlight unit 400 may have a seam portion 410a corresponding to a seam portion of the pattern structure 100. In the LCD 500 according to the present exemplary embodiment, the seam portion 410a of the grating layer 410 may be arranged at a position corresponding to the black matrix 540. In detail, the seam portion 410a of the grating layer 410 is located directly under the black matrix 540. As described above, a width of the seam portion 410a of the grating layer 410, for example, less than or equal to 10 µm, may be smaller than a width of the black matrix 540. As such, when the seam portion 410a, having a width that is smaller than that of the black matrix 540, is located under the black matrix 540, the seam portion 410a covered by the black matrix 540 is not visible, and thus, a flawless, large image may be displayed.

Also, a large-sized metal wire grid polarizer may be formed by using the above-described pattern structure 100 and stamp 300. For example, FIGS. 16 to 21 are cross-sectional views of a method of forming a large-sized metal wire grid polarizer by using the stamp 300.

First, referring to FIG. 16, a metal layer 620', a hard mask 630', and a resin layer 640' are sequentially formed on and above a support substrate 610. For example, a transparent glass substrate or a transparent polymer substrate, which are capable of transmitting visible light, may be used as the support substrate 610. For example, a metal material having conductivity, such as, gold (Au), silver (Ag), copper (Cu), aluminum (Al), etc. may be used as the metal layer 620', but the present disclosure is not limited thereto. The hard mask 630' may include a hard material. The resin layer 640' may include a flexible photocurable or thermosetting material.

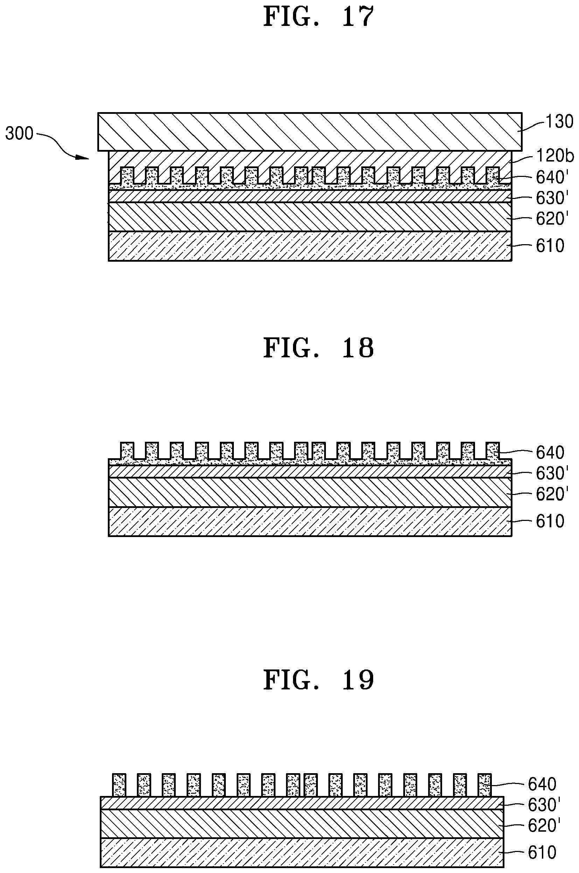

Next, referring to FIG. 17, the stamp 300 is pressed against the resin layer 640' so as to closely contact each other. The stamp 300 may be manufactured as illustrated in FIG. 12 or may be additionally manufactured, using the pattern structure 100 as a master mold. The stamp 300 may be arranged such that the resin portion 120b, having a complementary pattern, faces the resin layer 640'. Then, the resin layer 640', having flexibility, fills in the complementary patterns of the resin portion 120b. In this state, when light, for example, UV light, or heat is applied to the resin layer 640', the resin layer 640' is cured. Next, the stamp 300 is detached from the resin layer 640' and thus, as illustrated in FIG. 18, a patterned resin layer 640 is formed on the hard mask 630'.

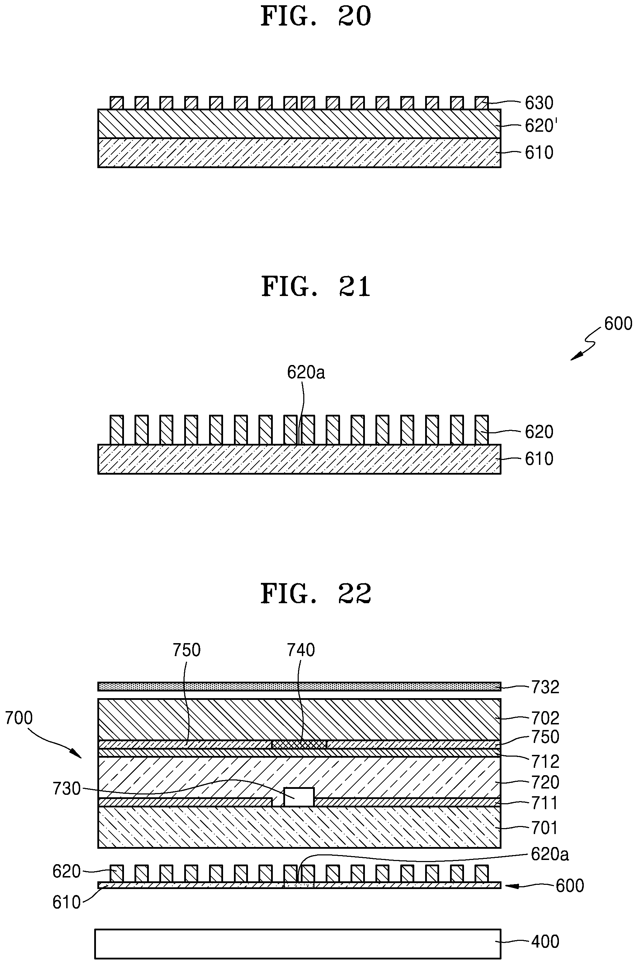

Referring to FIG. 19, an etching process is performed by using the patterned resin layer 640 as a mask and thus a resin material remaining on the hard mask 630' is removed. Referring to FIG. 20, the hard mask 630' is patterned by using the patterned resin layer 640 as a mask, and then the patterned resin layer 640 is removed. Then, a patterned hard mask 630 may be formed on the metal layer 620'.

Then, referring to FIG. 21, the metal layer 620' is patterned by using the patterned hard mask 630 as a mask, and then the patterned hard mask 630 is removed. Then, a metal wire grid polarizer 600, including a plurality of metal wire patterns 620 provided on the support substrate 610, may be completed. The metal wire patterns 620 may have the same pattern as the fine pattern P of the pattern structure 100. Accordingly, as illustrated in FIG. 21, a seam portion 620a corresponding to a seam portion of the pattern structure 100 may be formed in a middle portion of the metal wire patterns 620.

FIG. 22 is a cross-sectional view of an LCD 700 including the metal wire grid polarizer 600 manufactured by the method illustrated in FIGS. 16 to 21. Referring to FIG. 22, the LCD 700 may include a first substrate 701 and a second substrate 702, a liquid crystal layer 720 disposed in a space between the first substrate 701 and the second substrate 702, and the backlight unit 400, providing light toward the liquid crystal layer 720. Also, as described in FIG. 15, the LCD 700 may further include first electrodes 711, thin film transistors 730, a second electrode 712, color filters 750, and a black matrix 740.

The LCD 700 may further include the metal wire grid polarizer 600 facing the first substrate 701 and an absorptive polarizing panel 732 facing the second substrate 702. Although FIG. 22 illustrates that the absorptive polarizing panel 732 faces the second substrate 702 and the metal wire grid polarizer 600 is faces the first substrate 701, the present disclosure is not limited thereto and the positions of the absorptive polarizing panel 732 and the metal wire grid polarizer 600 may be reversed. The metal wire grid polarizer 600 characteristically reflects light that is polarized in a direction parallel to the metal wire patterns 620 and transmits light that is polarized in a direction perpendicular to the metal wire patterns 620. For example, the metal wire grid polarizer 600 may reflect an S-polarized wave and transmit a P-polarized wave. Accordingly, when the metal wire grid polarizer 600 is used, a reflected S-polarized wave is reused and thus loss of light may be reduced and brightness of the LCD 700 may be improved.

As exemplarily illustrated in FIG. 22, the metal wire patterns 620 of the metal wire grid polarizer 600 may have a seam portion 620a corresponding to the seam portion of the pattern structure 100. In the LCD 700 according to the present exemplary embodiment, the seam portion 620a of the metal wire patterns 620 may be disposed in a position corresponding to the position of black matrix 740. As described above, a width, for example, 10 µm or less, of the seam portion 620a of the metal wire patterns 620 may be smaller than the width of the black matrix 740. When the seam portion 620a, having a width smaller than the width of the black matrix 740, is located facing the black matrix 740, the seam portion 620a, covered by the black matrix 740, is not visible and thus a flawless, large image may be displayed.

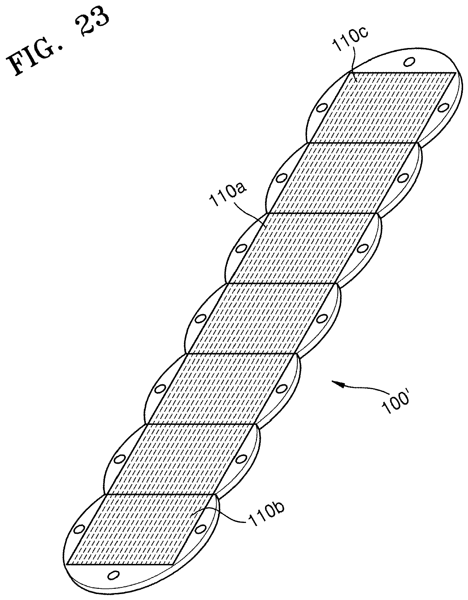

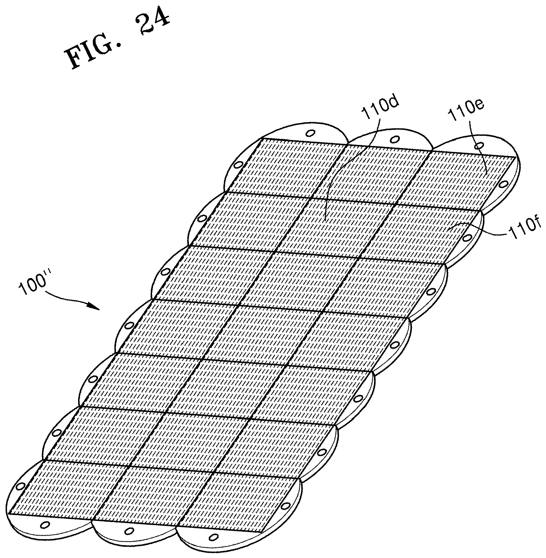

Although an example of manufacturing the pattern structure 100 by bonding two unit pattern structures 110 is described above, the pattern structure 100 may be manufactured in a larger size by bonding three or more unit pattern structures 110. The number of the unit pattern structures 110 to be bonded may be variously determined according to a size of the wafer W to be used in a semiconductor patterning process and a size of the pattern structure 100 to be implemented. For example, FIGS. 23 and 24 are perspective views of large-sized pattern structures 100' and 100" manufactured by using a tiling technology, according to other exemplary embodiments.

Referring to FIG. 23, the large-sized pattern structure 100' may be manufactured by linearly bonding a plurality of unit pattern structures 110a, 110b, and 110c. In FIG. 23, when the unit pattern structures 110a located in the middle portion of the large-sized pattern structure 100' are manufactured, opposite edge sides of a wafer may be cut in the method illustrated in FIG. 4, 7, or 8. However, when the unit pattern structures 110b and 110c located at opposite ends of the large-sized pattern structure 100' are manufactured, only one edge side of the wafer may be cut in the method illustrated in FIG. 4, 7, or 8. Then, after all unit pattern structures 110a, 110b, and 110c are arranged on a single substrate 200 of FIG. 9, the pattern structure 100' may be manufactured in the method illustrated in FIGS. 9 to 12. After the pattern structure 100' is completed, as desired, the other edge sides of the wafer where the alignment marks M are located may be removed. When the alignment mark M is removed, a stealth dicing technology or another dicing technology may be employed.

Referring to FIG. 24, the large-sized pattern structure 100" may be manufactured by arranging a plurality of unit pattern structures 110d, 110e, and 110f in two-dimensions and bonding the unit pattern structures 110d, 110e, and 110f to one another. In FIG. 24, when the unit pattern structure 110d, that is to be arranged completely inside the large-sized pattern structure 100", is manufactured, all four sides of each wafer therein may be cut in the method illustrated in FIG. 4, 7, or 8. Also, when the unit pattern structures 110e, that are to be located at the four corners of the large-sized pattern structure 100", are manufactured, two neighboring edge sides of each wafer may be cut in the method illustrated in FIG. 4, 7, or 8. When the unit pattern structures 110f, to be arranged along a side of the large-sized pattern structure 100", are manufactured, three edge sides of each wafer therein may be cut in the method illustrated in FIG. 4, 7, or 8. Then, after all unit pattern structures 110d, 110e, and 110f are arranged on a single substrate 200 of FIG. 9, the pattern structure 100" may be manufactured in the method illustrated in FIGS. 9 to 12.

It should be understood that the exemplary embodiments regarding the pattern structure and the method of manufacturing the pattern structure described herein should be considered in a descriptive sense only and not for purposes of limitation. Descriptions of features or aspects within each embodiment should typically be considered as available for other similar features or aspects in other exemplary embodiments.

While one or more exemplary embodiments have been described with reference to the figures, it will be understood by those of ordinary skill in the art that various changes in form and details may be made therein without departing from the scope as defined by the following claims.

## Claims

1. A method of manufacturing a pattern structure, the method comprising:
forming a fine pattern on a wafer;
cutting the wafer by irradiating the wafer with a laser, thereby forming a unit pattern structure having the fine pattern; and
bonding cutting surfaces of at least two unit pattern structures,
wherein the cutting the wafer comprises repeatedly irradiating the wafer with the laser and repeatedly moving a focal position of the laser in a horizontal direction and changing a focal depth of the laser, thereby forming a cutting surface profile in the unit pattern structure such that a first surface of the unit pattern structure on which the fine pattern is formed protrudes in the horizontal direction with respect to a second surface of the unit pattern structure that is opposite the first surface.

2. The method of claim 1, wherein a first region of the cutting surface profile extends from the first surface to a first depth in a depth direction and has a cutting surface that is substantially perpendicular to the first surface, and a second region of the cutting surface profile extends from the first depth to the second surface and has a cutting surface that is at least partially inclined with respect to the first surface, preferably wherein the cutting surface of the first region protrudes farther in the horizontal direction toward an edge of the unit pattern structure than the cutting surface of the second region; and/or wherein a thickness of the first region, from the first surface to the first depth, is not greater than 150 µm.

3. The method of claim 2,
wherein the moving the focal position of the laser in the horizontal direction and changing the focal depth of the laser comprises:
sequentially changing the focal depth of the laser in a direction from the second surface toward the first surface; and
moving the focal position of the laser in the horizontal direction toward the edge of the wafer when the focal depth of the laser is changed, preferably wherein the method further comprises stopping the sequentially changing the focal depth of the laser when the focal depth of the laser reaches the first depth and/or wherein the moving the focal position of the laser comprises gradually moving the focal position of the laser in the horizontal direction toward the edge of the wafer whenever the focal depth of the laser is changed.

4. The method of claim 3, wherein the moving the focal position of the laser comprises:
maintaining the focal position of the laser in the horizontal direction until the focal depth of the laser reaches a second depth between the first depth and the second surface; and
moving the focal position of the laser in the horizontal direction toward the edge of the wafer while the focal depth of the laser is changed between the second depth and the first depth, preferably wherein a distance by which the focal position of the laser is moved in the horizontal direction gradually increases as the focal depth of the laser is moved closer to the first depth and farther from the second depth; and/or wherein a distance between the first depth and the second depth is in a range of 50 µm to 200 µm.

5. The method of any of claims 1 to 4, wherein the bonding of the cutting surfaces of the at least two unit pattern structures comprises:
arranging the at least two unit pattern structures on a substrate;
providing a resin in a liquid state between the at least two unit pattern structures;
moving the at least two unit pattern structures such that the at least two unit pattern structures closely contact each other; and
curing the resin, wherein the resin comprises one of a photocurable resin and a thermosetting resin, preferably wherein the arranging of the at least two unit pattern structures on the substrate comprises arranging the at least two unit pattern structures such that the respective cutting surfaces of the at least two unit pattern structures face each other, more preferably wherein the arranging of the at least two unit pattern structures such that the at least two unit pattern structures closely contact each other comprises:
moving the at least two unit pattern structures toward each other such that the respective cutting surfaces of the at least two unit pattern structures closely contact each other; and
distributing the resin in the liquid state in a gap between the at least two unit pattern structures, above fine patterns of the at least two unit pattern structures, and under second surfaces of the at least two unit pattern structures, even more preferably wherein the distributing of the resin in the liquid state comprises:
positioning a base layer such that the base layer entirely covers the fine patterns of the at least two unit pattern structures; and
matching vertical positions of the respective fine patterns of the at least two unit pattern structures with each other by pressing the base layer toward the at least two unit pattern structures, even more preferably wherein the method further comprises detaching the base layer from the fine patterns of the at least two unit pattern structures, after the curing of the resin, even more preferably wherein the detaching the base layer comprises removing, with the base layer, a first portion of the cured resin arranged on the fine patterns of the at least two unit pattern structures, and separating the first portion of the cured resin from a second portion of the cured resin arranged in the gap between the at least two unit pattern structures and under the second surfaces of the at least two unit pattern structures.

6. The method of any of claims 1 to 5, wherein a gap between the cutting surfaces of the at least two unit pattern structures bonded to each other is greater than 0 µm and less than or equal to 10 µm.

7. A pattern structure comprising:
a first unit pattern structure comprising a first surface, on which a fine pattern is formed, a second surface opposite to the first surface, and a third surface extending from the first surface to the second surface; and
a second unit pattern structure comprising a first surface, on which a fine pattern is formed, a second surface opposite to the first surface, and a third surface extending from the first surface to the second surface,
wherein the third surface of first unit pattern structure is bonded to the third surface of the second unit pattern structure,
wherein, in each of the first unit pattern structure and the second unit pattern structure, the third surface has a sectional profile in which the first surface protrudes, in a horizontal direction substantially parallel to the first surface, with respect to the second surface; and
wherein, in each of the first unit pattern structure and the second unit pattern structure, a first region of the section profile extends from the first surface to a first depth in a depth direction and is substantially perpendicular to the first surface, and a second region of the section profile extends from the first depth to the second surface and is at least partially inclined.

8. The pattern structure of claim 7, wherein in each of the first unit pattern structure and the second unit pattern structure, the section profile of the first region protrudes farther in a direction toward an edge of the respective unit pattern structure than the section profile of the second region; and/or wherein, in each of the first unit pattern structure and the second unit pattern structure, a thickness of the first region is less than 150 µm; and/or wherein, in each of the first unit pattern structure and the second unit pattern structure, the section profile in the second region is inclined as a whole.

9. The pattern structure of claim 8, wherein, in each of the first unit pattern structure and the second unit pattern structure, a portion of the section profile in the second region, extending from the second surface to a second depth between the first depth and the second surface, is substantially vertical with respect to the first surface, and a portion of the section profile in the second region extending from the second depth to the first depth, is inclined with respect to the first surface, preferably wherein in each of the first unit pattern structure and the second unit pattern structure, the portion of the section profile in the second region extending from the second depth to the first depth has an inclination that gradually increases from the second depth toward the first depth and/or wherein in each of the first unit pattern structure and the second unit pattern structure, a thickness between the first depth and the second depth is in a range between 50 µm to 200 µm.

10. The pattern structure of any of claims 7 to 9, further comprising a resin layer disposed in a gap between the third surface of the first unit pattern structure and the third surface of the second unit pattern structure and under the second surfaces of the first unit pattern structure and the second unit pattern structure, preferably wherein a thickness of the resin layer under the second surface of the first unit pattern structure is different than a thickness of the resin layer under the second surface of the second unit pattern structure, and a position of the first surface of the first unit pattern structure and a position of the first surface of the second unit pattern structure are equal in a vertical direction, substantially normal to the first surface of the first unit pattern structure and the first surface of the second unit pattern structure; and/or wherein the gap between the third surface of the first unit pattern structure and the third surface of the second unit pattern structure is greater than 0 µm and less than or equal to 10 µm.

11. A method of forming a grating using a stamp, the stamp comprising two or more unit pattern regions adjacent to each other and a seam greater than 0 µm and less than or equal to 10 µm between the adjacent unit pattern regions, each of the unit pattern regions having a pattern, the method comprising:
pressing a resin layer with the stamp such that the resin layer fills complementary patterns of the patterns of the unit pattern regions;
curing the complementary patterns of the resin layer; and
detaching the stamp from the cured complementary patterns of the resin layer and thereby obtaining the grating having a seam between the complementary patterns greater than 0 µm and less than or equal to 10 µm;
wherein each of the unit pattern regions is the pattern structure of any of claims 7 to 10.

12. The method of claim 11, wherein the stamp further comprising:
a base layer having a flat surface; and
a resin portion disposed on the flat surface of the base layer,
wherein the unit pattern regions are disposed on the resin portion.

13. The method of claim 11 or 12, wherein the stamp is manufactured using a pattern structure as a master mold, the pattern structure comprising:
a first unit pattern structure comprising a first surface, on which a fine pattern is formed, a second surface opposite to the first surface, and a third surface extending from the first surface to the second surface; and
a second unit pattern structure comprising a first surface, on which a fine pattern is formed, a second surface opposite to the first surface, and a third surface extending from the first surface to the second surface,
wherein the third surface of first unit pattern structure is bonded to the third surface of the second unit pattern structure,
wherein, in each of the first unit pattern structure and the second unit pattern structure, the third surface has a sectional profile in which the first surface protrudes, in a horizontal direction substantially parallel to the first surface, with respect to the second surface, preferably wherein the grating has the same pattern as the fine pattern of the pattern structure and/or wherein the stamp is manufactured by:
distributing resin for replicating the stamp on the pattern structure;
pressing the resin for replicating the stamp by disposing a base layer on the resin for replicating the stamp;
curing the resin for replicating the stamp; and
detaching the base layer from the pattern structure.

14. The method of any of claims 11 to 13, wherein the grating is a grating layer disposed on a surface of a backlight unit for a liquid crystal display or a metal wire pattern of a wire grid polarizer for a liquid crystal display.

15. The method of any of claims 11 to 14, wherein the seam of the grating is disposed directly under a black matrix of the liquid crystal display and has a width smaller than a width of the black matrix.

## Patentansprüche

1. Verfahren zur Herstellung einer Musterstruktur, wobei das Verfahren Folgendes umfasst:
Formen eines feinen Musters auf einem Wafer;
Schneiden des Wafers durch Bestrahlen des Wafers mit einem Laser, dadurch Formen einer Einheitsmusterstruktur mit dem feinen Muster; und
Verbinden von Schnittflächen von mindestens zwei Einheitsmusterstrukturen, wobei das Schneiden des Wafers das wiederholte Bestrahlen des Wafers mit dem Laser und das wiederholte Bewegen einer Fokusposition des Lasers in einer horizontalen Richtung und das Ändern einer Fokustiefe des Lasers umfasst, wodurch ein Schnittflächenprofil in der Einheitsmusterstruktur geformt wird, so dass eine erste Oberfläche der Einheitsmusterstruktur, auf der das feine Muster geformt ist, in der horizontalen Richtung bezüglich einer zweiten Oberfläche der Einheitsmusterstruktur, die der ersten Oberfläche gegenüberliegt, vorsteht.

2. Verfahren nach Anspruch 1, wobei sich eine erst Region des Schnittflächenprofils von der ersten Oberfläche zu einer ersten Tiefe in einer Tiefenrichtung erstreckt und eine Schnittfläche aufweist, die im Wesentlichen senkrecht zur ersten Oberfläche ist, und sich eine zweite Region des Schnittflächenprofils von der ersten Tiefe zur zweiten Oberfläche erstreckt und eine Schnittfläche aufweist, die mindestens teilweise bezüglich der ersten Oberfläche geneigt ist, vorzugsweise wobei die Schnittfläche der ersten Region in der horizontalen Richtung zu einer Kante der Einheitsmusterstruktur weiter vorsteht als die Schnittfläche der zweiten Region; und/oder wobei eine Dicke der ersten Region, von der ersten Oberfläche zur ersten Tiefe, nicht größer als 150 µm ist.

3. Verfahren nach Anspruch 2,
wobei das Bewegen der Fokusposition des Lasers in der horizontalen Richtung und das Ändern der Fokustiefe des Lasers umfasst:
aufeinanderfolgendes Ändern der Fokustiefe des Lasers in einer Richtung von der zweiten Oberfläche zur ersten Oberfläche; und
Bewegen der Fokusposition des Lasers in der horizontalen Richtung zur Kante des Wafers, wenn die Fokustiefe des Lasers geändert ist, vorzugsweise wobei das Verfahren ferner das Anhalten des aufeinanderfolgenden Änderns der Fokustiefe des Lasers umfasst, wenn die Fokustiefe des Lasers die erste Tiefe erreicht, und/oder wobei das Bewegen der Fokusposition des Lasers das graduelle Bewegen der Fokusposition des Lasers in der horizontalen Richtung zur Kante des Wafers umfasst, immer wenn die Fokustiefe des Lasers geändert wird.

4. Verfahren nach Anspruch 3, wobei das Bewegen der Fokusposition des Lasers umfasst:
Halten der Fokusposition des Lasers in der horizontalen Richtung, bis die Fokustiefe des Lasers eine zweite Tiefe zwischen der ersten Tiefe und der zweiten Oberfläche erreicht; und
Bewegen der Fokusposition des Lasers in der horizontalen Richtung zur Kante des Wafers, während die Fokustiefe des Lasers zwischen der zweiten Tiefe und der ersten Tiefe geändert wird, vorzugsweise wobei eine Distanz, um die die Fokusposition des Lasers in der horizontalen Richtung bewegt wird, graduell zunimmt, während die Fokustiefe des Lasers näher zur ersten Tiefe und weiter von der zweiten Tiefe bewegt wird; und/oder wobei eine Distanz zwischen der ersten Tiefe und der zweiten Tiefe in einem Bereich von 50 µm bis 200 µm ist.

5. Verfahren nach einem der Ansprüche 1 bis 4, wobei das Verbinden der Schnittflächen der mindestens zwei Einheitsmusterstrukturen umfasst:
Anordnen der mindestens zwei Einheitsmusterstrukturen auf einem Substrat;
Bereitstellen eines Harzes in einem flüssigen Zustand zwischen den mindestens zwei Einheitsmusterstrukturen;
Bewegen der mindestens zwei Einheitsmusterstrukturen, so dass die mindestens zwei Einheitsmusterstrukturen einander nahe kontaktieren; und
Aushärten des Harzes, wobei das Harz eines eines lichthärtenden Harzes und eines wärmehärtenden Harzes umfasst, vorzugsweise wobei das Anordnen der mindestens zwei Einheitsmusterstrukturen auf dem Substrat das Anordnen der mindestens zwei Einheitsmusterstrukturen, so dass die jeweiligen Schnittflächen der mindestens zwei Einheitsmusterstrukturen zueinander zeigen, umfasst, weiter bevorzugt wobei das Anordnen der mindestens zwei Einheitsmusterstrukturen, so dass die mindestens zwei Einheitsmusterstrukturen einander nahe kontaktieren, umfasst:
Bewegen der mindestens zwei Einheitsmusterstrukturen zueinander, so dass die jeweiligen Schnittstellen der mindestens zwei Einheitsmusterstrukturen einander nahe kontaktieren; und
Verteilen des Harzes im flüssigen Zustand in einem Zwischenraum zwischen den mindestens zwei Einheitsmusterstrukturen über den feinen Mustern der mindestens zwei Einheitsmusterstrukturen und unter zweiten Oberflächen der mindestens zwei Einheitsmusterstrukturen, noch weiter bevorzugt wobei das Verteilen des Harzes im flüssigen Zustand umfasst:
Positionieren einer Basisschicht, so dass die Basisschicht die feinen Muster der mindestens zwei Einheitsmusterstrukturen abdeckt; und
Abgleichen vertikaler Positionen der jeweiligen feinen Muster der mindestens zwei Einheitmusterstrukturen miteinander durch Drücken der Basisschicht zu den mindestens zwei Einheitsmusterstrukturen, noch weiter bevorzugt wobei das Verfahren ferner das Abnehmen der Basisschicht von den feinen Mustern der mindestens zwei Einheitsmusterstrukturen, nach dem Härten des Harzes, umfasst, noch weiter bevorzugt wobei das Abnehmen der Basisschicht das Entfernen, mit der Basisschicht, eines auf den feinen Mustern der mindestens zwei Einheitsmusterstrukturen angeordneten ersten Abschnitts des gehärteten Harzes und das Trennen des ersten Abschnitts des im Zwischenraum zwischen den mindestens zwei Einheitsmusterstrukturen und unter den zweiten Oberflächen der mindestens zwei Einheitsmusterstrukturen angeordneten gehärteten Harzes umfasst.

6. Verfahren nach einem der Ansprüche 1 bis 5, wobei ein Zwischenraum zwischen den Schnittflächen der mindestens zwei miteinander verbundenen Einheitsmusterstrukturen größer als 0 µm und kleiner oder gleich 10 µm ist.

7. Musterstruktur, umfassend:
eine erste Einheitsmusterstruktur, umfassend eine erste Oberfläche, auf der ein feines Muster geformt ist, eine zweite Oberfläche gegenüber der ersten Oberfläche, und eine dritte Oberfläche, die sich von der ersten Oberfläche zur zweiten Oberfläche erstreckt; und
eine zweite Einheitsmusterstruktur, umfassend eine erste Oberfläche, auf der ein feines Muster geformt ist, eine zweite Oberfläche gegenüber der ersten Oberfläche, und eine dritte Oberfläche, die sich von der ersten Oberfläche zur zweiten Oberfläche erstreckt,
wobei die dritte Oberfläche der ersten Einheitsmusterstruktur mit der dritten Oberfläche der zweiten Einheitsmusterstruktur verbunden ist,
wobei, in jeder der ersten Einheitsmusterstruktur und der zweiten Einheitsmusterstruktur, die dritte Oberfläche ein Schnittprofil aufweist, in dem die erste Oberfläche in einer horizontalen Richtung, die im Wesentlichen parallel zur ersten Oberfläche ist, bezüglich der zweiten Oberfläche vorsteht; und
wobei, in jeder der ersten Einheitsmusterstruktur und der zweiten Einheitsmusterstruktur, sich eine erste Region des Schnittprofils von der ersten Oberfläche zu einer ersten Tiefe in einer Tiefenrichtung erstreckt und im Wesentlichen rechtwinklig zur ersten Oberfläche ist, und sich eine zweite Region des Schnittprofils von der ersten Tiefe zur zweiten Oberfläche erstreckt und mindestens teilweise geneigt ist.

8. Musterstruktur nach Anspruch 7, wobei in jeder der ersten Einheitsmusterstruktur und der zweiten Einheitsmusterstruktur, das Schnittprofil der ersten Region in einer Richtung zu einer Kante der jeweiligen Einheitsmusterstruktur weiter vorsteht als das Schnittprofil der zweiten Region; und/oder wobei, in jeder der ersten Einheitsmusterstruktur und der zweiten Einheitsmusterstruktur, eine Dicke der ersten Region kleiner als 150 µm ist; und/oder wobei, in jeder der ersten Einheitsmusterstruktur und der zweiten Einheitsmusterstruktur, das Schnittprofil in der zweiten Region als Ganzes geneigt ist.

9. Musterstruktur nach Anspruch 8, wobei, in jeder der ersten Einheitsmusterstruktur und der zweiten Einheitsmusterstruktur, ein Abschnitt des Schnittprofils in der zweiten Region, das sich von der zweiten Oberfläche zu einer zweiten Tiefe zwischen der ersten Tiefe und der zweiten Oberfläche erstreckt, bezüglich der ersten Oberfläche im Wesentlichen vertikal ist, und ein Abschnitt des Schnittprofils in der zweiten Region, der sich von der zweiten Tiefe zur ersten Tiefe erstreckt, bezüglich der ersten Oberfläche geneigt ist, vorzugsweise wobei in jeder der ersten Einheitsmusterstruktur und der zweiten Einheitsmusterstruktur der Abschnitt des Schnittprofils in der zweiten Region, der sich von der zweiten Tiefe zur ersten Tiefe erstreckt, eine Neigung aufweist, die von der zweiten Tiefe zur ersten Tiefe graduell zunimmt, und/oder wobei in jeder der ersten Einheitsmusterstruktur und der zweiten Einheitsmusterstruktur eine Dicke zwischen der ersten Tiefe und der zweiten Tiefe in einem Bereich zwischen 50 µm bis 200 µm ist.

10. Musterstruktur nach einem der Ansprüche 7 bis 9, ferner umfassend eine Harzschicht, die in einem Zwischenraum zwischen der dritten Oberfläche der ersten Einheitsmusterstruktur und der dritten Oberfläche der zweiten Einheitsmusterstruktur und unter den zweiten Oberflächen der ersten Einheitsmusterstruktur und der zweiten Einheitsmusterstruktur angeordnet ist, vorzugsweise wobei sich eine Dicke der Harzschicht unter der zweiten Oberfläche der ersten Einheitsmusterstruktur von einer Dicke der Harzschicht unter der zweiten Oberfläche der zweiten Einheitsmusterstruktur unterscheidet und eine Position der ersten Oberfläche der ersten Einheitsmusterstruktur und eine Position der ersten Oberfläche der zweiten Einheitsmusterstruktur in einer vertikalen Richtung, die im Wesentlichen senkrecht zur ersten Oberfläche der ersten Einheitsmusterstruktur und der ersten Oberfläche der zweiten Einheitsmusterstruktur ist, gleich ist; und/oder wobei der Zwischenraum zwischen der dritten Oberfläche der ersten Einheitsmusterstruktur und der dritten Oberfläche der zweiten Einheitsmusterstruktur größer als 0 µm und kleiner oder gleich 10 µm ist.

11. Verfahren zum Formen eines Rasters mithilfe eines Stempels, wobei der Stempel zwei oder mehr aneinander angrenzende Einheitsmusterregionen und einen Saum, der größer als 0 µm und kleiner oder gleich 10 µm ist, zwischen den angrenzenden Einheitsmusterregionen umfasst, wobei jede der Einheitsmusterregionen ein Muster aufweist, wobei das Verfahren umfasst:
Pressen einer Harzschicht mit dem Stempel, so dass die Harzschicht komplementäre Muster der Muster der Einheitsmusterregionen füllt;
Härten der komplementären Muster der Harzschicht; und
Abnehmen des Stempels von den gehärteten komplementären Mustern der Harzschicht und dadurch Erhalten des Rasters mit einem Saum zwischen den komplementären Mustern, der größer als 0 µm und kleiner oder gleich 10 µm ist;
wobei jede der Einheitsmusterregionen die Musterstruktur nach einem der Ansprüche 7 bis 10 ist.

12. Verfahren nach Anspruch 11, wobei der Stempel ferner umfasst:
eine Basisschicht mit einer ebenen Oberfläche; und
einen auf der ebenen Oberfläche der Basisschicht angeordneten Harzabschnitt, wobei die Einheitsmusterregionen auf dem Harzabschnitt angeordnet sind.

13. Verfahren nach Anspruch 11 oder 12, wobei der Stempel mithilfe einer Musterstruktur als Masterform hergestellt wird, wobei die Musterstruktur umfasst:
eine erste Einheitsmusterstruktur, umfassend eine erste Oberfläche, auf der ein feines Muster geformt ist, eine zweite Oberfläche gegenüber der ersten Oberfläche, und eine dritte Oberfläche, die sich von der ersten Oberfläche zur zweiten Oberfläche erstreckt; und
eine zweite Einheitsmusterstruktur, umfassend eine erste Oberfläche, auf der ein feines Muster geformt ist, eine zweite Oberfläche gegenüber der ersten Oberfläche, und eine dritte Oberfläche, die sich von der ersten Oberfläche zur zweiten Oberfläche erstreckt,
wobei die dritte Oberfläche der ersten Einheitsmusterstruktur mit der dritten Oberfläche der zweiten Einheitsmusterstruktur verbunden ist,
wobei, in jeder der ersten Einheitsmusterstruktur und der zweiten Einheitsmusterstruktur, die dritte Oberfläche ein Schnittprofil aufweist, in dem die erste Oberfläche in einer horizontalen Richtung, die im Wesentlichen parallel zur ersten Oberfläche ist, bezüglich der zweiten Oberfläche vorsteht, vorzugsweise wobei das Raster dasselbe Muster wie das feine Muster der Musterstruktur aufweist und/oder wobei der Stempel hergestellt wird durch:
Verteilen von Harz zum Reproduzieren des Stempels auf der Musterstruktur;
Pressen des Harzes zum Reproduzieren des Stempels durch Anordnen einer Basisschicht auf dem Harz zum Reproduzieren des Stempels;
Härten des Harzes zum Reproduzieren des Stempels; und
Abnehmen der Basisschicht von der Musterstruktur.

14. Verfahren nach einem der Ansprüche 11 bis 13, wobei das Raster eine Rasterschicht ist, die auf einer Oberfläche einer hintergrundbeleuchteten Einheit für eine Flüssigkristallanzeige oder ein Metalldrahtmuster eines Drahtrasterpolarisierers für eine Flüssigkristallanzeige angeordnet ist.

15. Verfahren nach einem der Ansprüche 11 bis 14, wobei der Saum des Rasters direkt unter einer schwarzen Matrix der Flüssigkristallanzeige angeordnet ist und eine Breite aufweist, die kleiner als eine Breite der schwarzen Matrix ist.

## Revendications

1. Procédé de fabrication d'une structure de motif, le procédé comprenant :
la formation d'un motif fin sur une plaquette ;
la découpe de la plaquette en exposant la plaquette au rayonnement d'un laser, formant ainsi une structure de motif unitaire présentant le motif fin ; et
la liaison des surfaces de découpe d'au moins deux structures de motif unitaire, ladite découpe de la plaquette comprenant une exposition répétée de la plaquette au rayonnement du laser et le déplacement répété d'une position focale du laser selon une direction horizontale et la modification de la profondeur focale du laser, formant ainsi un profil de surface de découpe dans la structure de motif unitaire de sorte qu'une première surface de la structure de motif unitaire sur laquelle le motif fin est formé fasse saillie selon la direction horizontale par rapport à une deuxième surface de la structure de motif unitaire qui est opposée à la première surface.

2. Procédé selon la revendication 1, une première zone du profil de surface de découpe s'étendant à partir de la première surface jusqu'à une première profondeur selon une direction de profondeur et possédant une surface de découpe qui est sensiblement perpendiculaire à la première surface et une seconde zone du profil de surface de découpe s'étendant à partir de la première profondeur jusqu'à la deuxième surface et possédant une surface de découpe au moins partiellement inclinée par rapport à la première surface, de préférence ladite surface de découpe de la première zone faisant saillie plus loin selon la direction horizontale vers un bord de la structure de motif unitaire que la surface de découpe de la seconde zone ; et/ou une épaisseur de la première zone, à partir de la première surface jusqu'à la première profondeur, n'étant pas supérieure à 150 µm.

3. Procédé selon la revendication 2,
ledit déplacement de la position focale du laser selon la direction horizontale et la modification de la profondeur focale du laser comprenant :
la modification séquentielle de la profondeur focale du laser selon une direction allant de la deuxième surface vers la première surface ; et
le déplacement de la position focale du laser selon la direction horizontale vers le bord de la plaquette lorsque la profondeur focale du laser est modifiée, de préférence ledit procédé comprenant en outre l'arrêt de la modification séquentielle de la profondeur focale du laser lorsque la profondeur focale du laser atteint la première profondeur et/ou ledit déplacement de la position focale du laser comprenant le déplacement progressif de la position focale du laser selon la direction horizontale vers le bord de la plaquette à chaque fois que la profondeur focale du laser est modifiée.

4. Procédé selon la revendication 3, ledit déplacement de la position focale du laser comprenant :
le maintien de la position focale du laser selon la direction horizontale jusqu'à ce que la profondeur focale du laser atteigne une seconde profondeur entre la première profondeur et la deuxième surface ; et
le déplacement de la position focale du laser selon la direction horizontale vers le bord de la plaquette pendant que la profondeur focale du laser est modifiée entre la seconde profondeur et la première profondeur, de préférence une distance de déplacement de la position focale du laser selon la direction horizontale augmentant progressivement tandis que la profondeur focale du laser se rapproche de la première profondeur et s'éloigne de la seconde profondeur ; et/ou une distance entre la première profondeur et la seconde profondeur étant comprise dans la plage allant de 50 µm à 200 µm.

5. Procédé selon l'une quelconque des revendications 1 à 4, ladite liaison des surfaces de découpe des au moins deux structures de motif unitaire comprenant :
l'agencement des au moins deux structures de motif unitaire sur un substrat ;
la fourniture d'une résine à l'état liquide entre les au moins deux structures de motifs unitaires ;
le déplacement des au moins deux structures de motif unitaire de sorte que les au moins deux structures de motif unitaire soient en contact étroit l'une avec l'autre ; et
le durcissement de la résine, ladite résine comprenant l'une d'une résine photodurcissable et d'une résine thermodurcissable, de préférence ledit agencement des au moins deux structures de motif unitaire sur le substrat comprenant l'agencement des au moins deux structures de motif unitaire de sorte que les surfaces de découpe respectives des au moins deux structures de motif unitaire soient en regard, de plus grande préférence, ledit agencement des au moins deux structures de motif unitaire, de sorte que les au moins deux structures de motif unitaire soient en contact étroit, comprenant :
le déplacement des au moins deux structures de motif unitaire l'une vers l'autre de sorte que les surfaces de découpe respectives des au moins deux structures de motif unitaire soient en contact étroit l'une avec l'autre ; et
la distribution de la résine à l'état liquide dans un intervalle entre les au moins deux structures de motif unitaire, au-dessus des motifs fins des au moins deux structures de motif unitaire, et sous des deuxièmes surfaces des au moins deux structures de motif unitaire, idéalement ladite distribution de la résine à l'état liquide comprenant :
le positionnement d'une couche de base de sorte que la couche de base recouvre entièrement les motifs fins des au moins deux structures de motif unitaire ; et
la mise en correspondance des positions verticales des motifs fins respectifs des au moins deux structures de motif unitaire l'une avec l'autre en pressant la couche de base vers les au moins deux structures de motif unitaire, idéalement ledit procédé comprenant en outre le détachement de la couche de base des motifs fins des au moins deux structures de motif unitaire, après le durcissement de la résine, idéalement le détachement de la couche de base comprenant l'enlèvement, avec la couche de base, d'une première partie de la résine durcie agencée sur les motifs fins des au moins deux structures de motif unitaire, et la séparation de la première partie de la résine durcie d'une seconde partie de la résine durcie agencée dans l'intervalle entre les au moins deux structures de motif unitaire et sous les deuxièmes surfaces des au moins deux structures de motif unitaire.

6. Procédé selon l'une quelconque des revendications 1 à 5, un intervalle entre les surfaces de découpe des au moins deux structures de motif unitaire liées l'une à l'autre étant supérieur à 0 µm et inférieur ou égal à 10 µm.

7. Structure de motif comprenant :
une première structure de motif unitaire comprenant une première surface sur laquelle un motif fin est formé, une deuxième surface opposée à la première surface et une troisième surface s'étendant à partir de la première surface jusqu'à la deuxième surface ; et
une deuxième structure de motif unitaire comprenant une première surface sur laquelle un motif fin est formé, une deuxième surface opposée à la première surface et une troisième surface s'étendant à partir de la première surface jusqu'à la deuxième surface,
ladite troisième surface de la première structure de motif unitaire étant liée à la troisième surface de la seconde structure de motif unitaire,
dans chacune de la première structure de motif unitaire et de la seconde structure de motif unitaire, la troisième surface possédant un profil transversale dans lequel la première surface fait saillie, selon une direction horizontale sensiblement parallèle à la première surface, par rapport à la deuxième surface ; et
dans chacune de la première structure de motif unitaire et de la seconde structure de motif unitaire, une première zone du profil de section s'étendant à partir de la première surface jusqu'à une première profondeur selon une direction de profondeur et étant sensiblement perpendiculaire à la première surface, et une seconde zone du profil de section s'étendant à partir de la première profondeur jusqu'à la deuxième surface et étant au moins partiellement inclinée.

8. Structure de motif selon la revendication 7, dans chacune de la première structure de motif unitaire et de la seconde structure de motif unitaire, ledit profil de section de la première zone faisant saillie plus loin selon la direction vers un bord de la structure de motif unitaire respectif que le profil de section de la seconde zone ; et/ou dans chacune de la première structure de motif unitaire et de la seconde structure de motif unitaire, une épaisseur de la première zone étant inférieure à 150 µm ; et/ou dans chacune de la première structure de motif unitaire et de la seconde structure de motif unitaire, ledit profil de section dans la seconde zone étant inclinée dans son ensemble.

9. Structure de motif selon la revendication 8, dans chacune de la première structure de motif unitaire et de la seconde structure de motif unitaire, une partie du profil de section dans la seconde zone, s'étendant à partir de la deuxième surface jusqu'à une seconde profondeur entre la première profondeur et la deuxième surface, étant sensiblement verticale par rapport à la première surface, et une partie du profil de section dans la seconde zone s'étendant à partir de la seconde profondeur jusqu'à la première profondeur étant inclinée par rapport à la première surface, de préférence dans chacune de la première structure de motif unitaire et de la seconde structure de motif unitaire, ladite partie du profil de section dans la seconde zone s'étendant à partir de la seconde profondeur jusqu'à la première profondeur possédant une inclinaison qui augmente progressivement à partir de la seconde profondeur vers la première profondeur et/ou dans chacune de la première structure de motif unitaire et de la seconde structure de motif unitaire, une épaisseur entre la première profondeur et la seconde profondeur étant comprise dans une plage allant de 50 µm à 200 µm.

10. Structure de motif selon l'une quelconque des revendications 7 à 9, comprenant en outre une couche de résine disposée dans un intervalle entre la troisième surface de la première structure de motif unitaire et la troisième surface de la seconde structure de motif unitaire et sous les deuxièmes surfaces de la première structure de motif unitaire et de la seconde structure de motif unitaire, de préférence une épaisseur de la couche de résine sous la deuxième surface de la première structure de motif unitaire étant différente de l'épaisseur de la couche de résine sous la deuxième surface de la seconde structure de motif unitaire, et une position de la première surface de la première structure de motif unitaire et une position de la première surface de la seconde structure de motif unitaire étant égales selon une direction verticale sensiblement perpendiculaire à la première surface de la première structure de motif unitaire et la première surface de la seconde structure de motif unitaire ; et/ou ledit intervalle entre la troisième surface de la première structure de motif unitaire et la troisième surface de la seconde structure de motif unitaire étant supérieur à 0 µm et inférieur ou égal à 10 µm.

11. Procédé de formation d'un réseau à l'aide d'un tampon, ledit tampon comprenant deux zones de motif unitaire adjacentes, ou plus, et une soudure supérieure à 0 µm et inférieure ou égale à 10 µm entre les zones de motif unitaire adjacentes, chacune des zones du motif unitaire possédant un motif, le procédé comprenant :
le pressage d'une couche de résine avec le tampon de sorte que la couche de résine remplisse des motifs complémentaires des motifs des zones de motif unitaire ;
le durcissement des motifs complémentaires de la couche de résine ; et
le détachement du tampon des motifs complémentaires durcis de la couche de résine et l'obtention ainsi du réseau possédant une soudure entre les motifs complémentaires supérieure à 0 µm et inférieure ou égale à 10 µm ;
chacune des zones de motif unitaire étant la structure de motif de l'une quelconque des revendications 7 à 10.

12. Procédé selon la revendication 11, ledit tampon comprenant en outre :
une couche de base possédant une surface plane ; et
une partie en résine disposée sur la surface plane de la couche de base, lesdites zones de motif unitaire étant disposées sur la partie résine.

13. Procédé selon la revendication 11 ou 12, ledit tampon étant fabriqué à l'aide d'une structure de motif en tant que moule maître, la structure de motif comprenant :
une première structure de motif unitaire comprenant une première surface sur laquelle un motif fin est formé, une deuxième surface opposée à la première surface et une troisième surface s'étendant à partir de la première surface jusqu'à la deuxième surface ; et
une deuxième structure de motif unitaire comprenant une première surface sur laquelle un motif fin est formé, une deuxième surface opposée à la première surface et une troisième surface s'étendant à partir de la première surface jusqu'à la deuxième surface,
ladite troisième surface de la première structure de motif unitaire étant liée à la troisième surface de la seconde structure de motif unitaire,
dans chacune de la première structure de motif unitaire et de la seconde structure de motif unitaire, la troisième surface possédant un profil transversal dans lequel la première surface fait saillie, selon une direction horizontale sensiblement parallèle à la première surface, par rapport à la deuxième surface, de préférence ledit réseau possédant le même motif que le motif fin de la structure de motif et/ou ledit tampon étant fabriqué en :
distribuant de la résine en vue de la reproduction du tampon sur la structure de motif ;
pressant la résine en vue de la reproduction du tampon en déposant une couche de base sur la résine en vue de la reproduction du tampon ;
durcissant la résine en vue de la reproduction du tampon ; et
en détachant la couche de base de la structure de motif.

14. Procédé selon l'une quelconque des revendications 11 à 13, ledit réseau étant une couche de réseau disposée sur une surface d'une unité de rétro-éclairage pour un dispositif d'affichage à cristaux liquides ou un motif de fil métallique d'un polariseur à grille de fils métalliques pour un dispositif d'affichage à cristaux liquides.

15. Procédé selon l'une quelconque des revendications 11 à 14, ladite soudure du réseau étant disposée directement sous une matrice noire du dispositif d'affichage à cristaux liquides et possédant une largeur inférieure à une largeur de la matrice noire.
